# EUROPÄISCHE PATENTSCHRIFT

(11) **EP 1 148 509 B1**
(45) Veröffentlichungstag und Bekanntmachung des Hinweises auf die Patenterteilung: **01.02.2012**
(21) Anmeldenummer: 01108486.0
(22) Anmeldetag: 04.04.2001
(51) Int. Cl.: G11C 7/06, G11C 16/28

(54) **Leseverstärker**
Sense amplifier
Amplificateur de lecture

(30) Priorität: 11.04.2000 DE 10017921
(43) Veröffentlichungstag der Anmeldung: 24.10.2001
(73) Patentinhaber: Infineon Technologies AG, 85579 Neubiberg (DE)
(72) Erfinder: Verbeck, Michael, Dr., 81827 München (DE)
(74) Vertreter: Jannig, Peter

(56) Entgegenhaltungen:
- EP-A- 0 491 105
- EP-A- 0 872 850
- US-A- 5 355 333

## Beschreibung

Die vorliegende Erfindung betrifft eine Vorrichtung gemäß dem Oberbegriff des Patentanspruchs 1, d.h. einen Leseverstärker zum Ermitteln des Inhaltes einer auszulesenden Speichereinrichtung, wobei die Ermittlung des Inhaltes der Speichereinrichtung unter Durchführung eines Vergleiches eines Stromes oder einer Spannung, der bzw. die dem Leseverstärker als ein den Inhalt der Speichereinrichtung charakterisierendes Eingangssignal zugeführt wird, und einem Schwellenwert erfolgt.

Solche Leseverstärker werden beispielsweise dazu verwendet, um in einem Halbleiter-Speicher (beispielsweise in einem EEPROM), genauer gesagt in dessen Speicherzellen gespeicherte Daten auszulesen.

Beim Auslesen einer Speicherzelle eines Halbleiter-Speichers tritt bekanntlich ein Strom oder eine Spannung auf, dessen bzw. deren Größe vom Inhalt der auszulesenden Speicherzelle abhängt. Der Leseverstärker vergleicht diesen Strom bzw. diese Spannung mit einem Schwellenwert, und bestimmt abhängig vom Ergebnis dieses Vergleiches den Inhalt der auszulesenden Speicherzelle.

Die Erfahrung zeigt, daß es mehr oder weniger häufig vorkommt, daß Leseverstärker den Inhalt einer der auszulesenden Speichereinrichtung wie beispielsweise einer Speicherzelle eines Halbleiter-Speichers nicht richtig ermitteln.

Solche Fehler lassen sich teilweise vermeiden, wenn man den Schwellenwert so festlegt, daß er genau in der Mitte der Ströme oder Spannungen liegt, die sich beim Auslesen einer Speicherzelle in Abhängigkeit von deren Inhalt einstellen. Aber auch dadurch kann nicht zuverlässig sichergestellt werden, daß der Leseverstärker den Inhalt der Speicherzelle immer richtig ermittelt.

Dokumente EP-A-0 872 850 und US-A-5 355 333 offenbaren einen Leseverstärker zum Ermitteln des Inhaltes einer auszulesenden Speichereinrichtung, wobei die Ermittlung des Inhaltes der Speichereinrichtung unter Durchführung eines Vergleiches eines Stromes oder einer Spannung mit einem Schwellenwert erfolgt.

Dokument EP-A-0 491 105 offenbart einen Leseverstärker zum Ermitteln des Inhaltes einer auszulesenden Speichereinrichtung, wobei die Ermittlung des Inhaltes der Speichereinrichtung unter Durchführung eines Vergleiches eines Stromes oder einer Spannung, der bzw. die dem Leseverstärker als ein den Inhalt der Speichereinrichtung charakterisierendes Eingangssignal zugeführt wird, und einem Schwellenwert erfolgt, wobei der Schwellenwert, den das den Inhalt der Speichereinrichtung charakterisierende Eingangssignal des Leseverstärkers überschreiten oder unterschreiten muß, damit ein den Inhalt der Speichereinrichtung repräsentierendes Ausgangssignal des Leseverstärkers von einem einen ersten Speichereinrichtungs-Inhalt repräsentierenden Zustand oder Verlauf in einen einen zweiten Speichereinrichtungs-Inhalt repräsentierenden Zustand oder Verlauf übergeht, höher oder niedriger ist, als der Schwellenwert, den das den Inhalt der Speichereinrichtung charakterisierende Eingangssignal des Leseverstärkers überschreiten oder unterschreiten muß, damit das Ausgangssignal des Leseverstärkers von einem den zweiten Speichereinrichtungs-Inhalt repräsentierenden Zustand oder Verlauf in einen den ersten Speichereinrichtungs-Inhalt repräsentierenden Zustand oder Verlauf übergeht.

Der vorliegenden Erfindung liegt daher die Aufgabe zugrunde, den Leseverstärker gemäß dem Oberbegriff des Patentanspruchs 1 derart weiterzubilden, daß die Gefahr einer nicht zutreffenden Bestimmung des Inhaltes einer Speichereinrichtung auf ein Minimum reduzierbar ist.

Diese Aufgabe wird erfindungsgemäß durch die im kennzeichnenden Teil des Patentanspruchs 1 beanspruchten Merkmale gelöst.

Demnach zeichnet sich der erfindungsgemäße Leseverstärker dadurch aus, daß der Schwellenwert, den das den Inhalt der Speichereinrichtung charakterisierende Eingangssignal des Leseverstärkers überschreiten oder unterschreiten muß, damit ein den Inhalt der Speichereinrichtung repräsentierendes Ausgangssignal des Leseverstärkers von einem einen ersten Speichereinrichtungs-Inhalt repräsentierenden Zustand oder Verlauf in einen einen zweiten Speichereinrichtungs-Inhalt repräsentierenden Zustand oder Verlauf übergeht, höher oder niedriger ist, als der Schwellenwert, den das den Inhalt der Speichereinrichtung charakterisierende Eingangssignal des Leseverstärkers überschreiten oder unterschreiten muß, damit das Ausgangssignal des Leseverstärkers von einem den zweiten Speichereinrichtungs-Inhalt repräsentierenden Zustand oder Verlauf in einen den ersten Speichereinrichtungs-Inhalt repräsentierenden Zustand oder Verlauf übergeht.

Dadurch kann verhindert werden, daß sich die im Leseverstärker einstellenden Zustände und damit gegebenenfalls auch das Ausgangssignal des Leseverstärkers während des Auslesens der Speichereinrichtung (beispielsweise einer Speicherzelle eines Halbleiter-Speichers) wiederholt ändern.

Eine wiederholte Änderung der sich im Leseverstärker einstellenden Zustände und des Ausgangssignals des Leseverstärkers tritt insbesondere auf, wenn innerhalb oder außerhalb des Leseverstärkers stattfindende Schaltvorgänge Veränderungen der Versorgungsspannung bewirken und/oder Störsignale erzeugen, die sich auf die Funktion des Leseverstärkers und/oder die Größe der durch diesen zu vergleichenden Ströme oder Spannungen auswirken. Dies kann dazu führen, daß der Leseverstärker und/oder das Ausgangssignal des Leseverstärkers regelrecht in Schwingungen versetzt werden. Dies ist vor allem dann der Fall, wenn die verschiedenen Ströme oder Spannungen, die beim Auslesen einer Speicherrichtung auftreten, relativ nahe beieinander liegen.

Durch eine geeignete Wahl der verschiedenen Schwellenwerte, die das in den Leseverstärker eingegebene Signal überschreiten bzw. unterschreiten muß, damit das Ausgangssignal des Leseverstärkers vom niedrigen Pegel auf den hohen Pegel bzw. vom hohen Pegel auf den niedrigen Pegel springt, kann erreicht werden, daß die vorstehend genannten Störungen keine Veränderung der sich im Leseverstärker einstellenden Zustände und/oder des Ausgangssignals zur Folge haben kann.

Da Leseverstärker wie auch beliebige andere Schaltungen in der Regel von Haus aus so aufgebaut sind, daß der störende Einfluß von Schaltvorgängen oder sonstigen Ereignissen auf die innerhalb und außerhalb der Schaltung auftretenden Ströme und Spannungen relativ gering ist, reicht eine relativ geringe Differenz zwischen den verschiedenen Schwellenwerten aus, um die auf solchen Störungen basierenden Effekte zu vermeiden. Dadurch ist gewährleistet, daß ein ausreichend großer Abstand zwischen den Schwellenwerten und den mit diesen Schwellenwerten zu vergleichen Strömen oder Spannungen existiert, so daß die Verwendung der verschiedenen Schwellenwerte keinen negativen Einfluß auf die Ermittlung des tatsächlichen Speicherzelleninhaltes hat.

Durch den erfindungsgemäßen Leseverstärker läßt sich somit die Gefahr einer nicht zutreffenden Bestimmung des Inhaltes einer Speichereinrichtung auf ein Minimum reduzieren.

Vorteilhafte Weiterbildungen der Erfindung sind den Unteransprüchen, der folgenden Beschreibung und den Figuren entnehmbar.

Die Erfindung wird nachfolgend anhand von Ausführungsbeispielen unter Bezugnahme auf die Figuren näher erläutert. Es zeigen
- Figur 1: die (Zellen-)Ströme, die beim Auslesen von Speicher- zellen eines Halbleiter-Speichers in Abhängigkeit von deren Inhalt in diese hinein oder aus dieser heraus fließen,
- Figur 2: den prinzipiellen Aufbau eines Leseverstärkers und dessen Anordnung in einem diesen enthaltenden System,
- Figur 3: den Aufbau eines Differenzverstärkers eines herkömm- lichen Leseverstärkers, und
- Figur 4: den Aufbau des nachfolgend näher beschriebenen Lese- verstärkers.

Der im folgenden näher beschriebene Leseverstärker ist Bestandteil einer integrierten Schaltung. Diese integrierte Schaltung ist im betrachteten Beispiel ein nicht flüchtiger Speicher, beispielsweise ein EEPROM-Baustein. Es sei jedoch bereits an dieser Stelle darauf hingewiesen, daß hierauf keine Einschränkung besteht. Ein die nachfolgend beschriebenen Besonderheiten aufweisender Leseverstärker kann auch als Leseverstärker für beliebige andere Speicher verwendet werden, deren Inhalt sich in Abhängigkeit von der Größe eines Stromes oder einer Spannung ermitteln läßt, der bzw. die sich beim Auslesen einstellt. Darüber hinaus muß der Leseverstärker auch nicht Bestandteil eines Speicherbausteins sein; er kann auch Bestandteil einer beliebigen anderen integrierten Schaltung sein (beispielsweise eines einen internen Speichers aufweisenden Mikrocontrollers), und kann auch als "normale" (nicht integrierte) Schaltung realisiert werden.

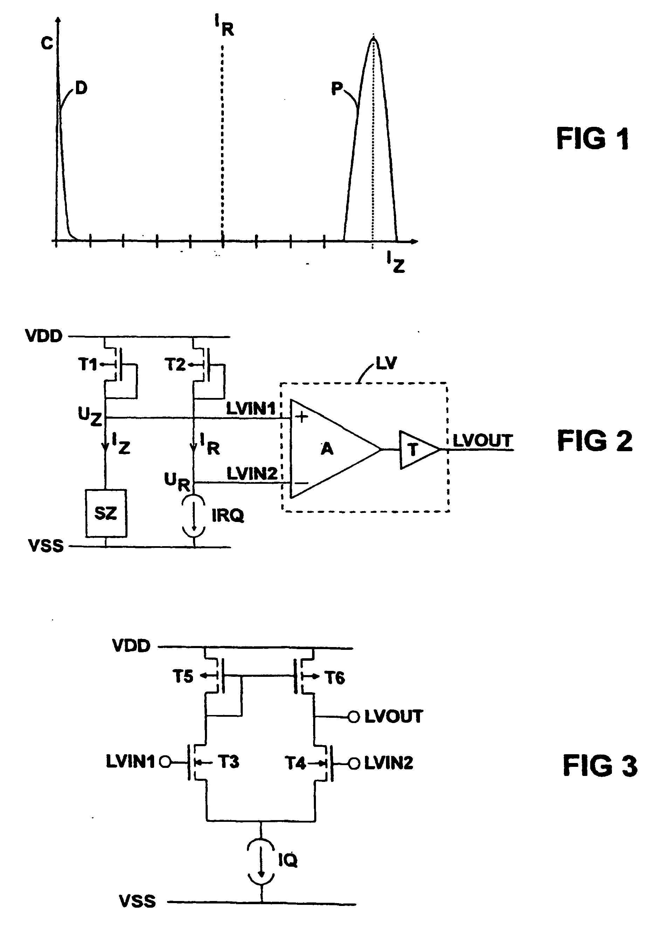

Zur Verdeutlichung der Unterschiede und der Gemeinsamkeiten zwischen herkömmlichen Leseverstärkern und dem vorliegend betrachteten Leseverstärker wird nun zunächst unter Bezugnahme auf die Figuren 1 bis 3 der Aufbau und die Funktion eines Leseverstärkers und dessen Anordnung in einem diesen enthaltenden System beschrieben.

Der betrachtete herkömmliche Leseverstärker vergleicht eine sich beim Auslesen der Speicherzelle, deren Inhalt der Leseverstärker ermitteln soll, einstellende Spannung mit einer Referenzspannung.

Die mit der Referenzspannung zu vergleichende Spannung hängt von dem sogenannten Zellenstrom ab, der auf der sogenannten Bitleitung in die auszulesende Speicherzelle hinein oder aus dieser herausfließt.

Die Größe dieses Zellenstromes hängt vom Inhalt der auszulesenden Speicherzelle ab.

Dies ist in Figur 1 veranschaulicht. In der Figur 1 ist dargestellt, wie groß der Zellenstrom bei den Speicherzellen eines Speichers ist, wenn die betreffenden Speicherzellen gelöscht sind bzw. wenn die betreffenden Speicherzellen programmiert sind. Dabei bezeichnen I_{z} den sich beim Auslesen der Speicherzellen einstellenden Zellenstrom, C die Anzahl der Zellen, bei deren Auslesen sich der jeweilige Zellenstrom I_{z} einstellt, D die Verhältnisse, wenn die Speicherzellen gelöscht sind, und P die Verhältnisse, wenn die Speicherzellen programmiert sind.

Die dem Leseverstärker zugeführte Referenzspannung basiert auf einem von einer Referenzstromquelle erzeugten Referenzstrom.

Der prinzipielle Aufbau des Leseverstärkers und dessen Anordnung in einem diesen enthaltenden System ist in Figur 2 gezeigt.

Die in der Figur 2 gezeigte Anordnung enthält einen Leseverstärker LV, eine unter Verwendung des Leseverstärkers auszulesende Speicherzelle SZ, eine Referenzstromquelle IRQ, und in Reihe zur Speicherzelle SZ und der Referenzstromquelle IRQ geschaltete PMOS-Transistoren T1 und T2; der Leseverstärker enthält einen Differenzverstärker A und einen diesem nachgeschalteten Ausgangstreiber T.

Beim Auslesen der Speicherzelle SZ fließt über den die Speicherzelle enthaltenden Schaltungszweig der in der Figur 2 gezeigten Anordnung der bereits erwähnte Zellenstrom I_{Z}. Die Referenzstromquelle IRQ erzeugt einen über den die Referenzstromquelle enthaltenden Schaltungszweig fließenden Referenzstrom I_{R}. Die (als Dioden wirkenden) Transistoren T1 und T2 dienen zur Strom/Spannungs-Wandlung und sorgen dafür, daß zwischen der Speicherzelle SZ und dem Transistor T1 eine vom Zellenstrom I_{Z} abhängende Spannung U_{Z}, und zwischen der Referenzstromquelle IRQ und dem Transistor T2 eine vom Referenzstrom I_{R} abhängende (Referenz-)Spannung U_{R} abgreifbar ist.

Der Leseverstärker LV weist einen ersten Eingangsanschluß LVIN1, einen zweiten Eingangsanschluß LVIN2, und einen Ausgangsanschluß LVOUT auf, wobei
- der erste Eingangsanschluß LVIN1 mit der Spannung U_{Z} beaufschlagt wird,
- der zweite Eingangsanschluß LVIN2 mit der Spannung U_{R} beaufschlagt wird, und
- der Ausgabeanschluß LVOUT ein Signal ausgibt, welches den Inhalt der auszulesenden Speicherzelle repräsentiert.

Der im Leseverstärker enthaltene Differenzverstärker A weist ebenfalls zwei Eingangsanschlüsse und einen Ausgangsanschluß auf, wobei
- der erste Eingangsanschluß des Differenzverstärkers mit dem ersten Eingangsanschluß LVIN1 des Leseverstärkers zusammenfällt, also mit der Spannung U_{Z} beaufschlagt wird,
- der zweite Eingangsanschluß des Differenzverstärkers mit dem zweiten Eingangsanschluß LVIN2 des Leseverstärkers zusammenfällt, also mit der Spannung U_{R} beaufschlagt wird, und
- das aus dem mit dem Bezugszeichen O bezeichneten Ausgangsanschluß ausgegebene Signal anzeigt, ob U_{Z} größer oder kleiner als U_{R} ist.

Der Aufbau des Differenzverstärkers A des betrachteten herkömmlichen Leseverstärkers LV ist in Figur 3 veranschaulicht.

Er weist eine einen Strom 2*I liefernde Stromquelle IQ, NMOS-Transistoren T3 und T4, und PMOS-Transistoren T5 und T6 auf, wobei die Transistoren T3 und T5 sowie die Transistoren T4 und T6 in zueinander parallelen und zur Stromquelle IQ in Reihe geschalteten Schaltungszweigen vorgesehen und innerhalb dieser Schaltungszweige in Reihe geschaltet sind.

Der Transistor T3 wird durch eine der miteinander zu vergleichenden Spannungen, genauer gesagt durch die Spannung U_{Z} angesteuert; der Gateanschluß des Transistors T3 ist mit dem ersten Eingangsanschluß LVIN1 des Leseverstärkers LV verbunden. Durch die am Gateanschluß des Transistors T3 anliegende Spannung U_{Z} wird dieser mehr oder weniger stark leitend, wodurch in dem die Transistoren T3 und T5 enthaltenden Schaltungszweig ein von der Spannung U_{Z} abhängender Strom fließt. Der Transistor T5 ist mit dem Transistor T6 zu einem Stromspiegel verschaltet, durch den bewirkt wird, daß durch den die Transistoren T4 und T6 enthaltenden Schaltungszweig der selbe Strom wie durch den die Transistoren T3 und T5 enthaltenden Schaltungszweig fließen kann. Welcher Strom in dem die Transistoren T4 und T6 enthaltenden Schaltungszweig tatsächlich fließt, hängt vom Zustand des Transistors T4 ab. Dieser Transistor T4 wird von der zweiten der miteinander zu vergleichenden Spannungen, d.h. durch die Spannung U_{R} angesteuert; der Gateanschluß des Transistors T4 ist mit dem zweiten Eingangsanschluß LVIN2 des Leseverstärkers A verbunden. Zwischen den Transistoren T4 und T6 stellt sich eine Spannung ein, die vom Verhältnis der durch die Transistoren T4 und T6 gebildeten Widerstände abhängt. Diese Spannung wird abgegriffen und als das durch den Differenzverstärker A zu ermittelnde Vergleichsergebnis aus diesem ausgegeben; der Abgriffspunkt ist mit dem Ausgangsanschluß O des Differenzverstärkers verbunden.

Die aus dem Differenzverstärker A ausgegebene Spannung wird dem Ausgangstreiber T zugeführt. Dieser setzt die vom Differenzverstärker A erhaltene Spannung je nach deren Vorzeichen und/oder Größe in eine den Pegel 0 oder den Pegel 1 repräsentierende Spannung um, und gibt diese aus dem Leseverstärker LV, genauer gesagt aus dem Ausgangsanschluß LVOUT desselben aus.

Der von der Referenzstromquelle IRQ erzeugte Referenzstrom I_{R} liegt vorzugsweise genau in der Mitte zwischen dem Zellenstrom I_{Z}, der sich einstellt, wenn die auszulesende Speicherzelle gelöscht ist, und dem Zellenstrom I_{Z}, der sich einstellt, wenn die betreffende Speicherzelle programmiert ist (siehe Figur 1). Entsprechendes gilt für die auf den Strömen I_{R} und I_{Z} basierenden Spannungen U_{R} und U_{Z}. Damit läßt sich aus der aus dem Differenzverstärker A bzw. dem Leseverstärker LV ausgegebenen Spannung ablesen, ob die auszulesenden Speicherzelle gelöscht oder programmiert ist.

Gegenüber einem solchen herkömmlichen Leseverstärker zeichnet sich der vorliegend betrachtete Leseverstärker dadurch aus, daß der Schwellenwert, den das den Inhalt der Speichereinrichtung charakterisierende Eingangssignal des Leseverstärkers überschreiten oder unterschreiten muß, damit ein den Inhalt der Speichereinrichtung repräsentierendes Ausgangssignal des Leseverstärkers von einem einen ersten Speichereinrichtungs-Inhalt repräsentierenden Zustand oder Verlauf in einen einen zweiten Speichereinrichtungs-Inhalt repräsentierenden Zustand oder Verlauf übergeht, höher oder niedriger ist, als der Schwellenwert, den das den Inhalt der Speichereinrichtung charakterisierende Eingangssignal des Leseverstärkers überschreiten oder unterschreiten muß, damit das Ausgangssignal des Leseverstärkers von einem den zweiten Speichereinrichtungs-Inhalt repräsentierenden Zustand oder Verlauf in einen den ersten Speichereinrichtungs-Inhalt repräsentierenden Zustand oder Verlauf übergeht.

Die Auswahl oder die Festlegung des beim Vergleich verwendeten Schwellenwertes erfolgt im betrachteten Beispiel abhängig vom jeweiligen Zustand oder Verlauf des Ausgangssignals des Leseverstärkers.

Vorliegend liegt der Schwellenwert, der verwendet wird, wenn das den Inhalt der Speichereinrichtung repräsentierende Ausgangssignal des Leseverstärkers den ersten Speichereinrichtungs-Inhalt repräsentiert, näher bei dem Eingangssignal des Leseverstärkers, das sich einstellt, wenn der Inhalt der Speichereinrichtung der zweite Speichereinrichtungs-Inhalt ist, als der Schwellenwert, der verwendet wird, wenn das den Inhalt der Speichereinrichtung repräsentierende Ausgangssignal des Leseverstärkers den zweiten Speichereinrichtungs-Inhalt repräsentiert.

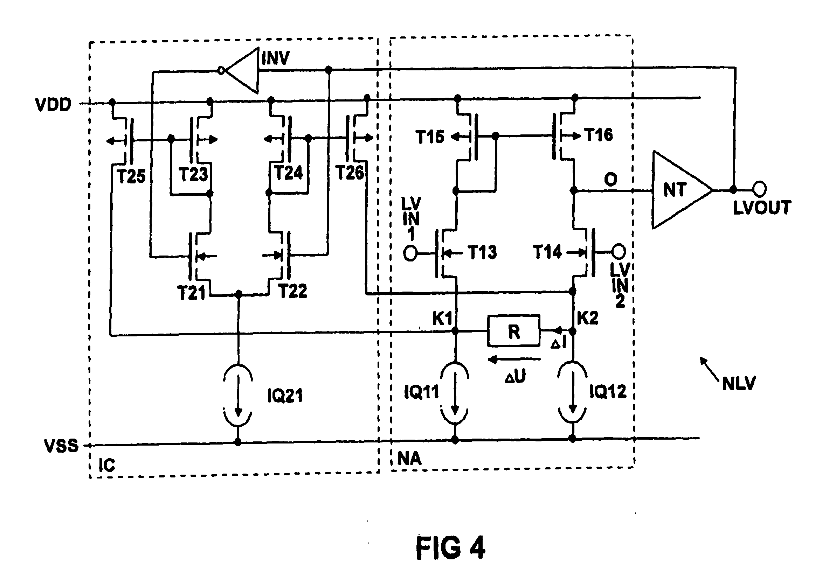

Ein Ausführungsbeispiel eines solchen Leseverstärkers ist in Figur 4 veranschaulicht.

Der betrachtete Leseverstärker ist mit dem Bezugszeichen NLV bezeichnet; er enthält einen Differenzverstärker NA und einen diesem nachgeschalteten Ausgangstreiber NT.

Der Leseverstärker NLV weist wie der beschriebene herkömmliche Leseverstärker LV einen ersten Eingangsanschluß LVIN1, einen zweiten Eingangsanschluß LVIN2, und einen Ausgangsanschluß LVOUT auf und ist dazu ausgelegt, genau so in ein diesen enthaltendes System integriert zu werden wie es bei dem vorstehend beschriebenen herkömmlichen Leseverstärker der Fall und beispielhaft in Figur 2 gezeigt ist.

Das heißt, daß
- der erste Eingangsanschluß LVIN1 mit einer den Inhalt der Speicherzelle charakterisierenden Spannung, also mit der Spannung U_{Z} beaufschlagt wird,
- der zweite Eingangsanschluß LVIN2 mit einer Referenzspannung, also mit der Spannung U_{R} beaufschlagt wird, und
- der Ausgangsanschluß LVOUT ein Signal ausgibt, welches den Inhalt der auszulesenden Speicherzelle repräsentiert.

Der im Leseverstärker enthaltene Differenzverstärker NA weist ebenfalls zwei Eingangsanschlüsse und einen Ausgangsanschluß auf, wobei
- der erste Eingangsanschluß des Differenzverstärkers NA mit dem ersten Eingangsanschluß LVIN1 des Leseverstärkers zusammenfällt, also mit der Spannung U_{Z} beaufschlagt wird,
- der zweite Eingangsanschluß des Differenzverstärkers NA mit dem zweiten Eingangsanschluß LVIN2 des Leseverstärkers zusammenfällt, also mit der Spannung U_{R} beaufschlagt wird, und
- das aus dem mit dem Bezugszeichen O bezeichneten Ausgangsanschluß ausgegebene Signal anzeigt, ob U_{Z} größer als U_{R} + ΔU oder kleiner als U_{R} - ΔU ist.

Der Differenzverstärker NA enthält einen Vergleichs-Teil VT und eine Stromsteuerstufe IC.

Der Vergleichsteil VT enthält jeweils einen Strom I + ΔI liefernde Stromquellen IQ11 und IQ12, NMOS-Transistoren T13 und T14, PMOS-Transistoren T15 und T16, und einen Widerstand R, wobei
- die erste Sromquelle IQ11, der erste NMOS-Transistor T13, und der erste PMOS-Transistor 15 in Reihe geschaltet sind,
- die zweite Sromquelle IQ12, der zweite NMOS-Transistor T14, und der zweite PMOS-Transistor 16 in Reihe geschaltet sind,
- der die Stromquelle IQ11, den NMOS-Transistor T13, und den PMOS-Transistor 15 enthaltende Schaltungszweig und der die Stromquelle IQ12, den NMOS-Transistor T14, und den PMOS-Transistor 16 enthaltende Schaltungszweig parallel zueinander angeordnet und an zwischen der Stromquelle IQ11 und dem Transistor T13 bzw. zwischen der Stromquelle IQ12 und dem Transistor T14 liegenden Knotenpunkten K1 und K2 über den Widerstand R miteinander verbunden sind.

Der Transistor T13 wird durch die Spannung U_{Z} angesteuert; der Gateanschluß des Transistors T13 ist mit dem ersten Eingangsanschluß des Differenzverstärkers NA verbunden. Durch die am Gateanschluß des Transistors T13 anliegende Spannung U_{Z} wird dieser mehr oder weniger stark leitend, wodurch in dem die Transistoren T13 und T15 enthaltenden Schaltungszweig ein von der Spannung U_{Z} abhängender Strom fließt. Der Transistor T15 ist mit dem Transistor T16 zu einem Stromspiegel verschaltet, durch den bewirkt wird, daß durch den die Transistoren T14 und T16 enthaltenden Schaltungszweig der selbe Strom fließen kann wie durch den die Transistoren T13 und T15 enthaltenden Schaltungszweig. Welcher Strom in dem die Transistoren T14 und T16 enthaltenden Schaltungszweig tatsächlich fließt, hängt vom Zustand des Transistors T14 ab. Dieser Transistor T14 wird durch die Spannung U_{R} angesteuert; der Gateanschluß des Transistors T14 ist mit dem zweiten Eingangsanschluß des Differenzverstärkers NA verbunden. Zwischen den Transistoren T14 und T16 stellt sich eine Spannung ein, die vom Verhältnis der durch die Transistoren T14 und T16 gebildeten Widerstände abhängt. Diese Spannung wird abgegriffen und über den Ausgangsanschluß O des Differenzverstärkers NA aus diesem ausgegeben. Das aus dem Differenzverstärker NA ausgegebene Signal wird dem Ausgangstreiber NT zugeführt. Dieser setzt die vom Differenzverstärker NA erhaltene Spannung je nach deren Vorzeichen und/oder Größe in eine den Pegel 0 oder den Pegel 1 repräsentierende Spannung um und gibt diese aus dem Leseverstärker NLV, genauer gesagt aus dem Ausgangsanschluß LVOUT desselben aus.

Wie vorstehend bereits erwähnt wurde, signalisiert die aus dem Ausgangsanschluß O des Differenzverstärkers NA und damit auch aus dem Ausgangsanschluß LVOUT des den Differenzverstärker NA enthaltenden Leseverstärker NLV ausgegebene Spannung nicht, ob U_{Z} größer oder kleiner als U_{R} ist, sondern ob U_{Z} größer als U_{R} + ΔU oder kleiner als U_{R} - ΔU ist.

Dies wird beim vorliegend betrachteten Leseverstärker dadurch erreicht, daß im Unterschied dem in Figur 3 gezeigten und unter Bezugnahme darauf beschriebenen herkömmlichen Differenzverstärker
- zwei Stromquellen IQ11 und IQ12,
- zusätzlich der Widerstand R, und
- zusätzlich die Stromsteuerstufe IC
vorgesehen sind.

Das vorstehend erwähnte ΔU ist die Spannung, die am Widerstand R abfällt, wenn dieser von einem Strom ΔI durchflossen wird und ist damit eine einer Offsetspannung des Leseverstärkers entsprechende oder wie eine Offsetspannung wirkende Spannung. Die Größe von ΔU ist durch die Größe des Widerstandes R und durch den über diesen fließenden Strom ΔI einstellbar. Diese Größen sind im betrachteten Beispiel so festgelegt, daß U_{R} + ΔU und U_{R} - ΔU nur wenig größer sind als U_{R}. U_{R} + ΔU ist noch deutlich kleiner als die Spannung U_{Z}, die dem Leseverstärker zugeführt wird, wenn eine programmierte Speicherzelle ausgelesen wird, und U_{R} - ΔU ist noch deutlich größer als die Spannung U_{Z}, die dem Leseverstärker zugeführt wird, wenn eine gelöschte Speicherzelle ausgelesen wird. Dabei ist zu berücksichtigen, daß die Spannung U_{Z}, die dem Leseverstärker beim Auslesen einer Speicherzelle zugeführt wird, sich mit zunehmendem Alter der Speichereinrichtung verändert: die Spannung U_{Z}, die dem Leseverstärker zugeführt wird, wenn eine programmierte Speicherzelle ausgelesen wird, kann mit zunehmendem Alter der Speichereinrichtung kleiner werden, und die Spannung U_{Z}, die dem Leseverstärker zugeführt wird, wenn eine gelöschte Speicherzelle ausgelesen wird, kann mit zunehmendem Alter der Speichereinrichtung größer werden. Dadurch, daß ΔU so klein ist, kann der Leseverstärker den Inhalt einer auszulesenden Speicherzelle nach wie vor sicher ermitteln. Andererseits kann durch den Umstand, daß der Leseverstärker U_{Z} nicht mehr mit U_{R}, sondern mit U_{R} + ΔU bzw. mit U_{R} - ΔU vergleicht, verhindert werden, daß durch Störungen verursachte Schwankungen der Versorgungsspannung und/oder von U_{Z} und/oder U_{R} gleich zu einer Änderung des Ausgangssignals 14 des Leseverstärkers führen; durch die nachfolgend noch näher beschriebene Stromsteuerstufe IC wird bewirkt, daß der Leseverstärker im Fall, daß sein Ausgangssignal signalisiert, daß die ausgelesene Speicherzelle programmiert ist, sein Ausgangssignal erst dann ändert, wenn U_{Z} kleiner wird als U_{R} - ΔU, und daß der Leseverstärker im Fall, daß sein Ausgangssignal signalisiert, daß die ausgelesene Speicherzelle gelöscht ist, sein Ausgangssignal erst dann ändert, daß wenn U_{Z} größer wird als U_{R} + ΔU. Dies ist insbesondere dann von Bedeutung, wenn U_{Z} und U_{R} aus den vorstehend genannten oder sonstigen Gründen relativ nahe beieinander liegen.

Wenn U_{Z} und U_{R} relativ nahe beieinander liegen
- liefern die Stromquellen IQ11 und IQ12 jeweils einen Strom I + ΔI,
- werden die die Transistoren T13 und T15 bzw. die Transistoren T14 und T16 enthaltenden Schaltungszweige jeweils von einem Strom I durchflossen,
- wird durch die Stromsteuerstufe IC am Knotenpunkt K1 oder am Knotenpunkt K2 ein Strom 2*ΔI eingeprägt, und
- fließt über den Widerstand R ein Strom ΔI, wobei die Richtung des Stromflusses davon abhängt, ob die Stromsteuerstufe IC am Knotenpunkt K1 oder dem Knotenpunkt K2 einen Strom einprägt.

Die bereits mehrfach erwähnte Stromsteuerstufe IC enthält eine einen Strom 2*ΔI liefernde Stromquelle IQ21, NMOS-Transistoren T21 und T22, PMOS-Transistoren T23 bis T26, und einen Inverter INV, wobei
- die Transistoren T21 und T23 sowie die Transistoren T22 und T24 in zueinander parallelen und zur Stromquelle IQ21 in Reihe geschalteten Schaltungszweigen vorgesehen und innerhalb dieser Schaltungszweige in Reihe geschaltet sind,
- die Transistoren T23 und T25 sowie die Transistoren T24 und T26 jeweils zu einem Stromspiegel verschaltet sind, durch welche in den Transistoren T25 und T26 die in den Transistoren T23 und T24 fließenden Ströme zum Fließen gebracht werden,
- der Gateanschluß des Transistors T22 mit dem Ausgangsanschluß des Ausgangstreibers NT, und der Gateanschluß des Transistors T21 über den Inverter INV mit dem Ausgangsanschluß des Ausgangstreibers NT verbunden ist.
- der Drainanschluß des Transistors T25 mit dem Knotenpunkt K1 des Vergleichsteils VT, und der Drainanschluß des Transistors T26 mit dem Knotenpunkt K2 des Vergleichsteils VT verbunden sind.

Wenn und so lange das Ausgangssignal des Leseverstärkers NLV (des Ausgangstreibers NT desselben) einen hohen Pegel aufweist leitet der Transistor T22, und sperrt der Transistor T21, wodurch durch den die Transistoren T22 und T24 enthaltenden Schaltungszweig der gesamte von der Stromquelle IQ21 gelieferte Strom, also 2*ΔI fließt. Dieser Strom wird durch den durch die Transistoren T24 und T26 gebildeten Stromspiegel in den Transistor T26 gespiegelt, so daß auch dieser von einem Strom 2*ΔI durchflossen wird. Dieser Strom wird in den Knotenpunkt K2 des Vergleichsteils VT eingeprägt. Da in diesem Stadium der Transistor T21 sperrt, kann durch die Transistoren T21, T23, und T25 kein Strom fließen, wodurch in den Knotenpunkt K1 des Vergleichsteils VT kein Strom eingeprägt wird. Das Einprägen eines Stromes 2*ΔI in den Knotenpunkt K2 bewirkt, daß über den Widerstand R ein ΔI betragender Ausgleichsstrom fließt. Dieser Stromfluß, genauer gesagt der sich als Folge dessen einstellende Spannungsabfall ΔU am Widerstand R bewirkt, daß der momentan hohe Pegel des aus dem Leseverstärker ausgegebenen Signals nicht schon auf den niedrigen Pegel abfällt, wenn die am Gateanschluß des Transistors T13 anliegende Spannung U_{Z} die am Gateanschluß des Transistors T14 anliegende Spannung U_{R} unterschreitet, sondern erst dann, wenn die am Gateanschluß des Transistors T13 anliegende Spannung U_{Z} die Spannung U_{R} - ΔU unterschreitet.

Wenn und so lange das Ausgangssignal des Leseverstärkers NLV (des Ausgangstreibers NT desselben) einen niedrigen Pegel aufweist leitet der Transistor T21, und sperrt der Transistor T22, wodurch durch den die Transistoren T21 und T23 enthaltenden Schaltungszweig der gesamte von der Stromquelle IQ21 gelieferte Strom, also 2*ΔI fließt. Dieser Strom wird durch den durch die Transistoren T23 und T25 gebildeten Stromspiegel in den Transistor T25 gespiegelt, so daß auch dieser von einem Strom 2*ΔI durchflossen wird. Dieser Strom wird in den Knotenpunkt K1 des Vergleichsteils VT eingeprägt. Da in diesem Stadium der Transistor T22 sperrt, kann durch die Transistoren T22, T24, und T26 kein Strom fließen, wodurch in den Knotenpunkt K2 des Vergleichsteils VT kein Strom eingeprägt wird. Das Einprägen eines Stromes 2*ΔI in den Knotenpunkt K1 bewirkt, daß über den Widerstand R ein ΔI betragender Ausgleichsstrom fließt. Dieser Stromfluß, genauer gesagt der sich als Folge dessen einstellende Spannungsabfall ΔU am Widerstand R bewirkt, daß der momentan niedrige Pegel des aus dem Leseverstärker ausgegebenen Signals nicht schon auf den hohen Pegel ansteigt, wenn die am Gateanschluß des Transistors T13 anliegende Spannung U_{Z} die am Gateanschluß des Transistors T14 anliegende Spannung U_{R} überschreitet, sondern erst dann, wenn die am Gateanschluß des Transistors T13 anliegende Spannung U_{Z} die Spannung U_{R} + ΔU überschreitet.

Ein wie beschrieben aufgebauter Leseverstärker vergleicht den Strom oder die Spannung, der bzw. die dem Leseverstärker als ein den Inhalt der auszulesenden Speicherzelle charakterisierendes Eingangssignal zugeführt wird, abhängig vom Ausgangssignal mit verschiedenen Schwellenwerten. Er vergleicht U_{Z} mit U_{R} - ΔU, wenn sein Ausgangssignal einen hohen Pegel aufweist, und er vergleicht U_{Z} mit U_{R} + ΔU, wenn sein Ausgangssignal einen niedrigen Pegel aufweist.

Es dürfte einleuchten, daß der beschriebene Leseverstärker mannigfaltig modifizierbar ist.

So ist es beispielsweise möglich, den Widerstand R durch ein anderes Element oder eine andere Anordnung zu ersetzen, an dem sich ein von dem Strom, von dem es durchflossen wird, abhängender Spannungsabfall einstellt. Ein solche Anordnung besteht beispielsweise aus einem oder mehreren Transistoren.

Ferner wäre es auch denkbar, die dem Leseverstärker zugeführte Spannung U_{Z} mit Schwellenwerten zu vergleichen, die nicht symmetrisch zur Referenzspannung U_{R} liegen, also mit einem ΔU zu arbeiten, bei welchem nicht nur das Vorzeichen, sondern auch der Betrag vom Ausgangssignal des Leseverstärkers abhängen.

Selbstverständlich kann eine wie beschrieben wirkende Stromsteuerstufe IC auch anders als beschrieben realisiert werden.

Es könnte auch vorgesehen werden, statt des beschriebenen Differenzverstärkers einen herkömmlichen Differenzverstärker vorzusehen und diesem eine vom Ausgangssignal des Leseverstärkers abhängende Referenzspannung zuzuführen (eine niedrige Referenzspannung zuzuführen, wenn das Ausgangssignal des Leseverstärkers einen hohen Pegel aufweist, und eine hohe Referenzspannung zuzuführen, wenn das Ausgangssignal des Leseverstärkers einen niedrigen Pegel aufweist). Es wäre auch denkbar, die den Inhalt der Speicherzelle charakterisierende Spannung und/oder die Versorgungsspannung für den Differenzverstärker in Abhängigkeit vom Ausgangssignal des Differenzverstärkers zu variieren.

Durch die Verwendung eines wie beschrieben oder ähnlich arbeitenden Leseverstärker läßt sich die Gefahr einer nicht zutreffenden Bestimmung des Inhaltes einer auszulesenden Speichereinrichtung auf ein Minimum reduzieren.

### Bezugszeichenliste

- A: Differenzverstärker
- C: Speicherzellen-Anzahl
- D: Verhältnisse, wenn auszulesende Speicherzellen gelöscht sind
- IC: Stromsteuerstufe von NA
- INV: Inverter
- I_{R}: Referenzstrom
- IRQ: Referenzstromquelle
- IQ: Stromquelle in A
- IQ1x: Stromquellen von VT
- IQ21: Stromquelle von IC
- I_{Z}: Zellenstrom
- Kx: Knotenpunkte
- LV: Leseverstärker
- LVINx: Eingangsanschlüsse von LV und NLV
- LVOUT: Ausgangsanschluß von LV und NLV
- NA: Differenzverstärker
- NLV: Leseverstärker
- NT: Ausgangstreiber
- 0: Ausgangsanschluß von A
- P: Verhältnisse, wenn auszulesende Speicherzellen programmiert sind
- R: Widerstand
- SZ: Speicherzelle
- T: Ausgangstreiber
- Tx: Transistoren
- U_{R}: auf I_{R}/U-Wandlung basierende Spannung
- U_{Z}: auf I_{Z}/U-Wandlung basierende Spannung
- VT: Vergleichsteil von NA

## Patentansprüche

1. Leseverstärker (NLV) zum Ermitteln des Inhaltes einer auszulesenden Speichereinrichtung (SZ), wobei die Ermittlung des Inhaltes der Speichereinrichtung (SZ) unter Durchführung eines Vergleiches eines Stromes (I_{Z}) oder einer Spannung (U_{Z}), der bzw. die dem Leseverstärker (NLV) als ein den Inhalt der Speichereinrichtung (SZ) charakterisierendes Eingangssignal zugeführt wird, und einem Schwellenwert erfolgt, wobei der Schwellenwert, den das den Inhalt der Speichereinrichtung (SZ) charakterisierende Eingangssignal (I_{Z}, U_{Z}) des Leseverstärkers (NLV) überschreiten oder unterschreiten muß, damit ein den Inhalt der Speichereinrichtung (SZ) repräsentierendes Ausgangssignal des Leseverstärkers (NLV) von einem einen ersten Speichereinrichtungs-Inhalt repräsentierenden Zustand oder Verlauf in einen einen zweiten Speichereinrichtungs-Inhalt repräsentierenden Zustand oder Verlauf übergeht, höher oder niedriger ist, als der Schwellenwert, den das den Inhalt der Speichereinrichtung (SZ) charakterisierende Eingangssignal des Leseverstärkers (NLV) überschreiten oder unterschreiten muß, damit das Ausgangssignal des Leseverstärkers (NLV) von einem den zweiten Speichereinrichtungs-Inhalt repräsentierenden Zustand oder Verlauf in einen den ersten Speichereinrichtungs-Inhalt repräsentierenden Zustand oder Verlauf übergeht,
**dadurch gekennzeichnet,**
**daß** der Leseverstärker (NLV) einen Differenzverstärker (NA) mit einer ersten Stromquelle (IQ11), einer zweiten Stromquelle (IQ12), und einem die Ausgangsanschlüsse der Stromquellen (IQ11, IQ12) miteinander verbindenden Widerstand (R) enthält, und
**daß** der Leseverstärker (NLV) ferner eine Stromsteuerstufe (IC) enthält, die am Ausgangsanschluß der ersten Stromquelle (IQ11) oder am Ausgangsanschluß der zweiten Stromquelle (IQ12) einen zusätzlichen Strom einprägt.

2. Leseverstärker nach Anspruch 1,
**dadurch gekennzeichnet,**
**daß** das Ausgangssignal des Leseverstärkers (NLV) angibt, ob das den Inhalt der Speichereinrichtung (SZ) charakterisierende Eingangssignal (I_{Z}, U_{Z}) des Leseverstärkers (NLV) kleiner oder größer ist als der vor dem letzten Umschalten des Ausgangssignals des Leseverstärkers verwendete Schwellenwert.

3. Leseverstärker nach einem der vorhergehenden Ansprüche,
**dadurch gekennzeichnet,**
**daß** der Schwellenwert, der verwendet wird, wenn das den Inhalt der Speichereinrichtung (SZ) repräsentierende Ausgangssignal des Leseverstärkers (NLV) den ersten Speichereinrichtungs-Inhalt repräsentiert, näher bei dem Eingangssignal (I_{Z}, U_{Z}) des Leseverstärkers (NLV) liegt, das sich einstellt, wenn der Inhalt der Speichereinrichtung (SZ) der zweite Speichereinrichtungs-Inhalt ist, als der Schwellenwert, der verwendet wird, wenn das den Inhalt der Speichereinrichtung (SZ) repräsentierende Ausgangssignal des Leseverstärkers den zweiten Speichereinrichtungs-Inhalt repräsentiert.

4. Leseverstärker nach einem der vorhergehenden Ansprüche,
**dadurch gekennzeichnet,**
**daß** die auszulesende Speichereinrichtung (SZ) eine Speicherzelle eines Halbleiterspeichers ist.

5. Leseverstärker nach einem der vorhergehenden Ansprüche,
**dadurch gekennzeichnet,**
**daß** an den einen Eingangsanschluß (LVIN1) des Differenzverstärkers (NA) eine den Inhalt der auszulesenden Speichereinrichtung (SZ) charakterisierende Spannung (U_{Z}) angelegt wird, und an den anderen Eingangsanschluß (LVIN2) des Differenzverstärkers (NA) eine Referenzspannung (U_{R}) angelegt wird.

6. Leseverstärker nach Anspruch 5,
**dadurch gekennzeichnet,**
**daß** der Differenzverstärker (NA) dazu ausgelegt ist, einen Vergleich der den Eingangsanschlüssen (LVIN1,LVIN2) zugeführ ten Spannungen (U_{Z}, U_{R}) durchzuführen, wobei jedoch der Vergleich durch eine im Differenzverstärker (NA) erzeugte, einer Offsetspannung entsprechenden oder wie eine Offsetspannung wirkende Spannung gezielt gestört wird.

7. Leseverstärker nach Anspruch 6,
**dadurch gekennzeichnet,**
**daß** die im Differenzverstärker (NA) erzeugte, einer Offsetspannung entsprechende oder wie eine Offsetspannung wirkende Spannung betrags- und/oder vorzeichenmäßig veränderbar ist.

8. Leseverstärker nach Anspruch 6 oder 7,
**dadurch gekennzeichnet,**
**daß** die im Differenzverstärker (NA) erzeugte, einer Offsetspannung entsprechende oder wie eine Offsetspannung wirkende Spannung abhängig vom Ausgangssignal des Differenzverstärkers (NA) betrags- und/oder vorzeichenmäßig verändert wird.

9. Leseverstärker nach einem der Ansprüche 5 bis 8,
**dadurch gekennzeichnet,**
**daß** das Ausgangssignal des Differenzverstärkers (NA) angibt, ob die den Inhalt der auszulesenden Speichereinrichtung (SZ) charakterisierende Spannung größer als eine erste SchwellenSpannung oder kleiner als eine gegenüber der ersten Schwellenspannung kleinere zweite Schwellenspannung ist.

10. Leseverstärker nach Anspruch 9,
**dadurch gekennzeichnet,**
**daß** die erste Schwellenspannung größer als die Referenzspannung (U_{R}) ist.

11. Leseverstärker nach Anspruch 9 oder 10,
**dadurch gekennzeichnet,**
**daß** die zweite Schwellenspannung kleiner als die Referenzspannung (U_{R}) ist.

12. Leseverstärker nach Anspruch 10 oder 11,
**dadurch gekennzeichnet,**
**daß** die Differenz zwischen der ersten Schwellenspannung und der Referenzspannung (U_{R}) und/oder die Differenz zwischen der zweiten Schwellenspannung und der Referenzspannung (U_{R}) von der im Differenzverstärker erzeugten, einer Offsetspannung entsprechenden oder wie eine Offsetspannung wirkenden Spannung abhängt.

13. Leseverstärker nach einem der Ansprüche 6 bis 12,
**dadurch gekennzeichnet,**
**daß** die Erzeugung der einer Offsetspannung entsprechenden oder wie eine Offsetspannung wirkenden Spannung durch das Einprägen des zusätzlichen Stromes in den Differenzverstärker (NA) bewirkt wird.

14. Leseverstärker nach Anspruch 13,
**dadurch gekennzeichnet,**
**daß** eine den zusätzlichen Strom einprägende Stromsteuerstufe (IC) abhängig vom Ausgangssignal des Leseverstärkers arbeitet.

15. Leseverstärker nach Anspruch 14,
**dadurch gekennzeichnet,**
**daß** die Stromsteuerstufe (IC) den zusätzlichen Strom an einer vom Ausgangssignal des Leseverstärkers (NLV) abhängenden Stelle des Differenzverstärkers (NA) einprägt.

16. Leseverstärker nach einem der Ansprüche 13 bis 15,
**dadurch gekennzeichnet,**
**daß** die im Differenzverstärker (NA) erzeugte, einer Offsetspannung entsprechende oder wie eine Offsetspannung wirkende Spannung die Spannung ist, die an dem im Differenzverstärker (NA) vorgesehenen Widerstand (R) abfällt, wobei der den Spannungsabfall hervorrufende Stromfluß durch den Widerstand (R) von dem in den Differenzverstärker (NA) eingeprägten zusätzlichen Strom abhängt.

17. Leseverstärker nach Anspruch 16,
**dadurch gekennzeichnet,**
**daß** die Richtung des durch den Widerstand (R) fließenden Stromes von der Stelle abhängt, an welcher der Strom in den Differenzverstärker eingeprägt wird.

## Claims

1. Sense amplifier (NLV) for ascertaining the content of a memory (SZ) device which is to be read, where the content of the memory device (SZ) is ascertained by comparing a current (I_{Z}) or voltage (U_{Z}) which is supplied to the sense amplifier (NLV) as an input signal characterizing the content of the memory device (SZ), and a threshold value, wherein the threshold value which the sense amplifier's (NLV) input signal (I_{Z}, U_{Z}) characterizing the content of the memory device (SZ) needs to exceed or fall below in order for an output signal from the sense amplifier (NLV), which represents the content of the memory device (SZ), to change from a state or profile which represents a first memory device content to a state or profile which represents a second memory device content is higher or lower than the threshold value which the sense amplifier's (NLV) input signal characterizing the content of the memory device (SZ) needs to exceed or fall below in order for the output signal from the sense amplifier (NLV) to change from a state or profile which represents the second memory device content to a state or profile which represents the first memory device content,
**characterized**
**in that** the sense amplifier (NLV) contains a differential amplifier (NA) having a first current source (IQ11), a second current source (IQ12) and a resistor (R) that connects the output connections of the current sources (IG11, IQ12) to one another, and in that the sense amplifier (NLV) also contains a current control stage (IC) which impresses an additional current on the output connection of the first current source (IQ11) or on the output connection of the second current source (IQ12).

2. Sense amplifier according to Claim 1,
**characterized**
**in that** the output signal from the sense amplifier (NLV) indicates whether the sense amplifier's (NLV) input signal (I_{Z}, U_{Z}) characterizing the content of the memory device (SZ) is below or above the threshold value used before the output signal from the sense amplifier last changed over.

3. Sense amplifier according to one of the preceding claims,
**characterized**
**in that** the threshold value used when the sense amplifier's (NLV) output signal, representing the content of the memory device (SZ), represents the first memory device content is closer to the sense amplifier's (NLV) input signal (I_{Z}, U_{Z}) established when the content of the memory device (SZ) is the second memory device content than the threshold value used when the sense amplifier's output signal, representing the content of the memory device (SZ), represents the second memory device content.

4. Sense amplifier according to one of the preceding claims,
**characterized**
**in that** the memory device (SZ) which is to be read is a memory cell in a semiconductor memory.

5. Sense amplifier according to one of the preceding claims,
**characterized**
**in that** one input connection (LVIN1) of the differential amplifier (NA) has a voltage (U_{Z}) characterizing the content of the memory device (SZ) which is to be read applied to it, and the other input connection (LVIN2) of the differential amplifier (NA) has a reference voltage (U_{R}) applied to it.

6. Sense amplifier according to Claim 5,
**characterized**
**in that** the differential amplifier (NA) is designed to compare the voltages (U_{Z}, U_{R}) supplied to the input connections (LVIN1, LVIN2), but the comparison is specifically perturbed by a voltage which is produced in the differential amplifier (NA) and which corresponds to an offset voltage or acts as an offset voltage.

7. Sense amplifier according to Claim 6,
**characterized**
**in that** the magnitude and/or arithmetic sign of the voltage which is produced in the differential amplifier (NA) and corresponds to an offset voltage or acts as an offset voltage can be charged.

8. Sense amplifier according to Claim 6 or 7,
**characterized**
**in that** the magnitude and/or arithmetic sign of the voltage which is produced in the differential amplifier (NA) and corresponds to an offset voltage or acts as an offset voltage are/is changed on the basis of the output signal from the differential amplifier (NA).

9. Sense amplifier according to one of Claims 5 to 8,
**characterized**
**in that** the output signal from the differential amplifier (NA) indicates whether the voltage characterizing the content of the memory device (SZ) which is to be read is higher than a first threshold voltage or lower than a second threshold voltage, which is lower than the first threshold voltage.

10. Sense amplifier according to Claim 9,
**characterized**
**in that** the first threshold voltage is higher than the reference voltage (U_{R}).

11. Sense amplifier according to Claim 9 or 10,
**characterized**
**in that** the second threshold voltage is lower than the reference voltage (U_{R}).

12. Sense amplifier according to Claim 10 or 11,
**characterized**
**in that** the difference between the first threshold voltage and the reference voltage (U_{R}) and/or the difference between the second threshold voltage and the reference voltage (U_{R}) is dependent on the voltage which is produced in the differential amplifier and corresponds to an offset voltage or acts as an offset voltage.

13. Sense amplifier according to one of Claims 6 to 12,
**characterized**
**in that** the voltage which corresponds to an offset voltage or acts as an offset voltage is produced by impressing the additional current into the differential amplifier (NA).

14. Sense amplifier according to Claim 13,
**characterized**
**in that** a current control stage (IC) which impresses the additional current operates on the basis of the output signal from the sense amplifier.

15. Sense amplifier according to Claim 14,
**characterized**
**in that** the current control stage (IC) impresses the additional current at a point of the differential amplifier (NA) which is dependent on the output signal from the sense amplifier (NLV).

16. Sense amplifier according to one of Claims 13 to 15,
**characterized**
**in that** the voltage which is produced in the differential amplifier (NA) and corresponds to an offset voltage or acts as an offset voltage is the voltage which drops across the resistor (R) provided in the differential amplifier (NA), with the flow of current through the resistor (R) which produces the voltage drop being dependent on the additional current impressed into the differential amplifier (NA).

17. Sense amplifier according to Claim 16,
**characterized**
**in that** the direction of the current flowing through the resistor (R) is dependent on the point at which the current is impressed into the differential amplifier.

## Revendications

1. Amplificateur de lecture (NLV) destiné à déterminer le contenu d'un dispositif de mémoire (SZ) qui doit être lu, la détermination du contenu du dispositif de mémoire (SZ) s'effectuant en comparant à une valeur de seuil un courant (I_{Z}) ou une tension (U_{Z}) apportées à l'amplificateur ou aux amplificateurs de lecture (NLV) comme signal d'entrée qui caractérise le contenu du dispositif de mémoire (SZ),
la valeur de seuil qui doit dépasser ou rester inférieure au signal d'entrée (I_{Z}, U_{Z}) de l'amplificateur de lecture (NLV) qui caractérise le contenu du dispositif de mémoire (SZ) pour qu'un signal de sortie de l'amplificateur de lecture (NLV) qui représente le contenu du dispositif de mémoire (SZ) passe d'un état ou d'une évolution qui représentent un premier contenu du dispositif de mémoire à un deuxième état ou une deuxième évolution qui représentent un deuxième contenu du dispositif de mémoire étant supérieure ou inférieure à la valeur de seuil que le signal d'entrée de l'amplificateur de lecture (NLV) qui caractérise le contenu du dispositif de mémoire (SZ) doit dépasser ou ne pas atteindre pour que le signal de lecture de l'amplificateur de lecture (NLV) passe d'un état ou d'une évolution qui représentent le deuxième contenu du dispositif de mémoire à un état ou une évolution qui représentent le premier contenu du dispositif de mémoire,
**caractérisé en ce que**
l'amplificateur de lecture (NLV) contient un amplificateur différentiel (NA) qui présente une première source de courant (IQ11), une deuxième source de courant (IQ12) et une résistance (R) qui relie l'une à l'autre les bornes d'entrée des sources de courant (IQ11, IQ12) et
**en ce que** l'amplificateur de lecture (NLV) contient en outre un étage (IC) de commande de courant qui applique un courant supplémentaire sur la borne de sortie de la première source de courant (IQ11) ou sur la borne de sortie de la deuxième source de courant (IQ12).

2. Amplificateur de lecture selon la revendication 1, **caractérisé en ce que** le signal de sortie de l'amplificateur de lecture (NLV) indique si le signal d'entrée (I_{Z}, U_{Z}) de l'amplificateur de lecture (NLV) qui caractérise le contenu du dispositif de mémoire (SZ) est inférieur ou supérieur à la valeur de seuil utilisée avant le dernier basculement du signal de sortie de l'amplificateur de lecture.

3. Amplificateur de lecture selon l'une des revendications précédentes, **caractérisé en ce que** la valeur de seuil utilisée lorsque le signal de sortie de l'amplificateur de lecture (NLV) qui représente le contenu du dispositif de mémoire (SZ) représente le premier contenu du dispositif de mémoire est plus proche du signal d'entrée (I_{Z}, U_{Z}) de l'amplificateur de lecture (NLV) qui s'établit lorsque le contenu du dispositif de mémoire (SZ) est le deuxième contenu du dispositif de mémoire que la valeur de seuil qui est utilisée lorsque le signal de sortie de l'amplificateur de lecture qui représente le contenu du dispositif de mémoire (SZ) représente le deuxième contenu du dispositif de mémoire.

4. Amplificateur de lecture selon l'une des revendications précédentes, **caractérisé en ce que** le dispositif de mémoire (SZ) qui doit être lu est une cellule de mémoire d'une mémoire à semi-conducteur.

5. Amplificateur de lecture selon l'une des revendications précédentes, **caractérisé en ce qu'**une tension (U_{Z}) qui caractérise le contenu du dispositif de mémoire (SZ) qui doit être lu est appliquée sur une des bornes d'entrée (LVIN1) de l'amplificateur différentiel (NA) et **en ce qu'**une tension de référence (U_{R}) est appliquée sur l'autre borne d'entrée (LVIN2) de l'amplificateur différentiel (NA).

6. Amplificateur de lecture selon la revendication 5, **caractérisé en ce que** l'amplificateur différentiel (NA) est conçu pour exécuter une comparaison entre les tensions (U_{Z}, U_{R}) qui sont apportées aux bornes d'entrée (LVIN1, LVIN2), mais pour perturber de manière contrôlée la comparaison par une tension, formée dans l'amplificateur différentiel (NA), qui correspond à une tension de décalage ou qui agit comme une tension de décalage.

7. Amplificateur de lecture selon la revendication 6, **caractérisé en ce que** la tension formée dans l'amplificateur différentiel (NA) et qui correspond à une tension de décalage ou agit comme une tension de décalage peut avoir son niveau et/ou son signe modifiés.

8. Amplificateur de lecture selon la revendication 6 ou 7, **caractérisé en ce que** la tension formée dans l'amplificateur différentiel (NA) et qui correspond à une tension de décalage ou qui agit comme une tension de décalage peut avoir son niveau et/ou son signe modifiés en fonction du signal de sortie de l'amplificateur différentiel (NA).

9. Amplificateur de lecture selon l'une des revendications 5 à 8, **caractérisé en ce que** le signal de sortie de l'amplificateur différentiel (NA) indique si la tension qui caractérise le contenu du dispositif de mémoire (SZ) qui doit être lu est supérieure à une première tension de seuil ou inférieure à une deuxième tension de seuil plus petite que la première tension de seuil.

10. Amplificateur de lecture selon la revendication 9, **caractérisé en ce que** la première tension de seuil est supérieure à la tension de référence (U_{R}).

11. Amplificateur de lecture selon la revendication 9 ou 10, **caractérisé en ce que** la deuxième tension de seuil est inférieure à la tension de référence (U_{R}).

12. Amplificateur de lecture selon la revendication 10 ou 11, **caractérisé en ce que** la différence entre la première tension de seuil et la tension de référence (U_{R}) et/ou la différence entre la deuxième tension de seuil et la tension de référence (U_{R}) dépend(ent) de la tension formée dans l'amplificateur différentiel et qui correspond à une tension de décalage ou qui agit comme une tension de décalage.

13. Amplificateur de lecture selon l'une des revendications 6 à 12, **caractérisé en ce que** la formation de la tension qui correspond à une tension de décalage ou qui agit comme une tension de décalage est obtenue en appliquant le courant supplémentaire dans l'amplificateur différentiel (NA) .

14. Amplificateur de lecture selon la revendication 13, **caractérisé en ce que** l'étage (IC) de commande de courant qui applique un courant supplémentaire travaille en fonction du signal de sortie de l'amplificateur de lecture.

15. Amplificateur de lecture selon la revendication 14, **caractérisé en ce que** l'étage (IC) de commande de courant applique le courant supplémentaire sur un emplacement de l'amplificateur différentiel (NA) qui dépend du signal de sortie de l'amplificateur de lecture (NLV).

16. Amplificateur de lecture selon l'une des revendications 13 à 15, **caractérisé en ce que** la tension formée dans l'amplificateur différentiel (NA) et qui correspond à une tension de décalage ou qui agit comme une tension de décalage est la chute de tension aux bornes de la résistance (R) prévue dans l'amplificateur différentiel (NA), l'intensité du courant qui traverse la résistance (R) et qui provoque la chute de tension dépendant du courant supplémentaire appliqué dans l'amplificateur différentiel (NA).

17. Amplificateur de lecture selon la revendication 16, **caractérisé en ce que** la direction du courant qui traverse la résistance (R) dépend de l'emplacement sur lequel le courant est appliqué dans l'amplificateur différentiel.
